**Europäisches Patentamt**

**European Patent Office**

**Office européen des brevets**

(19)

(11) Numéro de publication : **0 370 444 B1**

## FASCICULE DE BREVET EUROPEEN

(12)

(45) Date de publication du fascicule du brevet :
**25.01.95 Bulletin 95/04**

(51) Int. Cl.⁶ : **H03M 13/22**

(21) Numéro de dépôt : **89121470.2**

(22) Date de dépôt : **20.11.89**

(54) **Procédé d'entrelacement pour dispositif de transmission numérique.**

(30) Priorité : **25.11.88 FR 8815422**

(43) Date de publication de la demande :
**30.05.90 Bulletin 90/22**

(45) Mention de la délivrance du brevet :
**25.01.95 Bulletin 95/04**

(84) Etats contractants désignés :
**CH DE ES FR GB IT LI NL SE**

(56) Documents cités :
**EP-A- 0 232 043**
**EP-A- 0 235 477**
**DE-A- 2 240 057**
**FR-A- 2 486 680**
**US-A- 4 394 642**
**US-A- 4 547 887**
**IEEE INTERNATIONAL CONFERENCE ON COMMUNICATIONS vol. 1, 19 juin 1983, BOSTON,MASSACHUSETTS pages 509 - 513; S.Y.MUI: "THE PERFORMANCE OF PSEUDO-RANDOM INTERLEAVING IN CONJUNCTION WITH VITERBI DECODING OF CONVOLUTIONAL CODES"**

(56) Documents cités :
**NATIONAL TELECOMMUNICATIONS CONFERENCE - NTC vol. 3, 29 novembre 1979,WASHINGTON,DC J.B.CAIN AND J.M.GEIST: "INTERLEAVING CONSIDERATIONS FOR CONVOLUTIONAL CODING ON GAUSSIAN NOISE CHANNELS WITH BURST ERASURES "Page 44.5.1.-44.5.5**
**CLARCK AND CAIN: "ERROR CORRECTING CODING" 1981, PLENUM PRESS, NEW YORK , US**

(73) Titulaire : **ALCATEL TELSPACE**
**5, rue Noel Pons**
**F-92734 Nanterre Cédex (FR)**
(84) **DE ES FR GB IT NL SE**
Titulaire : **ALCATEL N.V.**
**Strawinskylaan 341,**
**(World Trade Center)**
**NL-1077 XX Amsterdam (NL)**
(84) **CH LI**

(72) Inventeur : **Sadot, Philippe**
**5, passage Bullourde**
**F-75011 Paris (FR)**
Inventeur : **Darmon, Marc**
**21 rue Barbet de Jouy**
**F-75007 Paris (FR)**
Inventeur : **Harari, Sami**
**c/o A.T.F.H.**
**55, rue Greffulhe**
**F-92301 Levallois Perret Cedex (FR)**

(74) Mandataire : **Weinmiller, Jürgen et al**
**Lennéstrasse 9**
**Postfach 24**
**D-82336 Feldafing (DE)**

EP 0 370 444 B1

## Description

La présente invention se rapporte à un procédé d'entrelacement pseudo-aléatoire apte à être utilisé pour la transmission numérique d'informations.

En transmission numérique, il est courant de procéder, avant de les émettre, à un entrelacement des symboles afin de lutter contre les "paquets" d'erreurs. Dans le train reçu en effet, s'il est aisé de corriger les erreurs isolées grâce au codage correcteur d'erreurs, en revanche cette correction n'est plus possible si ces erreurs arrivent "en paquet", c'est à dire sous la forme d'un relativement grand nombre d'erreurs successives car, dans un tel cas, la capacité de correction du code est dépassée. Pour palier à cet inconvénient, il est connu, lorsque les informations émises sont codées au moyen d'un code correcteur d'erreurs, d'entrelacer, après le codage, les symboles pour éviter qu'un paquet d'erreurs ne vienne masquer plusieurs mots entiers. Ainsi, grâce à l'entrelacement, les symboles d'un même mot ne sont pas regroupés, mais ils sont répartis sur les mots successifs qui sont effectivement émis, de façon qu'un paquet d'erreurs ne puisse masquer tous les symboles d'un même mot d'origine (mot codé avant entrelacement). Bien entendu, les symboles ainsi émis sont désentrelacés à la réception, et ils sont alors remis à leur bonne place dans le mot. Si seulement quelques symboles isolés sont erronés, le code correcteur d'erreurs restitue le mot exact.

Un mode particulièrement simple d'entrelacement connu est par exemple l'entrelacement matriciel, pour lequel les symboles sont entrelacés suivant une certaine loi, et de manière répétitive. Si chaque mot contient N symboles successifs, on peut convenir de constituer le premier mot effectivement émis par la suite des premiers symboles des N premiers mots d'origine (c'est-à-dire après codage de correction d'erreurs), puis de constituer le deuxième mot effectivement émis par la suite des deuxièmes symboles de ces N premiers mots, puis le troisième mot par la suite des troisièmes symboles de ces N premiers mots, et ainsi de suite.

Ce mode d'entrelacement est efficace pour lutter contre les paquets d'erreurs accidentelles, c'est à dire ne provenant pas d'un brouillage volontairement effectué par un ennemi, en revanche sa répétitivité le rend facilement attaquable en cas de guerre électronique, et donc totalement inefficace dans un tel cas.

Le document DE-A-2.240.057 décrit un tel procédé d'entrelacement pour un dispositif de transmission numérique.

Ce procédé consiste à remplir initialement un vecteur par une première série S1 des Tv premiers symboles de la suite des mots codés à transmettre et, à chacune des adresses de ce vecteur, données l'une après l'autre par une suite-pilote, à prélever, pour l'incorporer dans la suite-canal à émettre, le symbole qui s'y trouve tout en le remplaçant aussitôt à cette même adresse par le symbole suivant, dans l'ordre des mots codés, de la série S2 des Tv symboles suivants, jusqu'à ce que tous les symboles de cette première série S1 aient été l'un après l'autre prélevés et remplacés par tous les symboles de cette deuxième série S2.

Une adresse du vecteur ne peut, au cours de l'émission des symboles d'une série Sn et de leur remplacement concommitant dans ce vecteur par ceux d'une série Sn+1, être choisie plusieurs fois.

Dans ce procédé, les échantillons à transmettre sont entrelacés suivant un agencement préprogrammé et le traitement est répétitif pour tous les deux vecteurs. Ainsi, l'entrelacement proposé par ce document présente une très faible périodicité, qui ne peut convenir dans des milieux de transmission volontairement brouillés.

Pour lutter contre les brouillages pouvant être effectués en cas de guerre électronique, il est connu de faire appel à un procédé d'entrelacement pseudo-aléatoire. Dans un tel cas, les symboles ne sont pas entrelacés de manière répétitive, mais ils le sont d'une manière pseudo-aléatoire, de façon que personne ne puisse savoir, sans avoir connaissance de la loi d'entrelacement pseudo-aléatoire, où se trouvent, dans le message reçu, les différents symboles d'un même mot d'origine.

La qualité d'un entrelacement, pseudo-aléatoire ou non, est mesurée par la distance minimale Lm, après entrelacement, de deux symboles initialement consécutifs d'un même mot codé. Pour un code corrigeant t erreurs et une longueur estimée de brouillage de Lc, il faut : Lm > Lc/t.

Un procédé connu d'entrelacement pseudo-aléatoire consiste à écrire séquentiellement dans un vecteur de taille M, et à lire successivement les symboles aux adresses : $Xn = (Xo + n.p) \bmod M$, où p est un nombre premier avec M. On change p et Xo à chaque vecteur transmis. Pour les meilleures valeurs de p que l'on puisse trouver, la séparation entre deux symboles du même mot est deux fois inférieure, à retard et taille des mémoires-tampon égaux, à la séparation d'un entrelaceur matriciel. Un autre inconvénient de ce procédé connu est qu'il n'aboutit pas à un entrelacement réellement pseudo-aléatoire.

L'art antérieur propose aussi un entrelaceur pseudo-aléatoire composé d'un entrelaceur convolutionnel suivi d'un permuteur de longueur L. Les permutations s'effectuent en écrivant L symboles dans un vecteur, puis en les lisant suivant une suite d'adresses pseudo-aléatoires. Par rapport à l'entrelaceur matriciel, pour un entrelacement équivalent (c'est-à-dire de même distance minimale entre deux symboles initialement consécutifs dans le train d'origine), cet entrelaceur connu a pour inconvénient de nécessiter une mémoire-tampon deux fois plus importante. En outre, cet entrelaceur n'est pas dépourvu de périodicité. En effet, si l'on considère un symbole d'un mot donné, par exemple un mot de verrouillage de trame, la position de celui-ci dans le train binaire du canal est comprise dans une fenêtre de L bits : il est donc relativement facile pour l'ennemi de le détruire.

L'invention vise à remédier à ces inconvénients et, d'une manière générale, à obtenir un entrelacement de bonne qualité (grande distance après entrelacement entre les différents symboles d'un même mot d'origine), réellement pseudo-aléatoire, utilisant des mémoires-tampon de taille réduite, et ne nécessitant pas un délai de restitution trop grand pour des paramètres comparables. Ces résultats sont obtenus par un procédé d'entrelacement conforme à la revendication 1.

D'autres caractéristiques de l'invention ressortiront de la description suivante de deux exemples non limitatifs d'entrelacements réalisés au moyen de ce procédé.

Pour les deux exemples qui vont être décrits maintenant, il est admis que chaque mot de code est composé de deux symboles. La distance minimale Lm, après entrelacement, de deux symboles initialement consécutifs est, dans ces deux exemples, choisie égale à trois.

Pour le premier exemple, il est fait choix d'un vecteur, ou registre, de taille Tv minimale soit :

$$Tv = Tc . Lm = 2.3 = 6$$

La suite de symboles à émettre est, en sortie du dispositif de codage situé en amont, la suivante :

a b c d e f g h i j k l m n o p q r s t u v w...

Le registre est tout d'abord rempli, à ses six adresses : 1, 2, 3, 4, 5, 6, par les six premiers symboles à émettre : a b c d e f

La première adresse de la suite pilote est prise au hasard parmi les six adresses du registre, par exemple : 4.

En conséquence, le contenu de l'adresse 4, c'est-à-dire le symbole d, est émis et il constitue donc le premier symbole de la suite canal. Il est immédiatement remplacé par le premier symbole à émettre et faisant suite aux six premiers, donc par le symbole g.

Le contenu du registre devient alors : a b c g e f. Conformément à la première loi I ci-dessus définie, le contenu de l'adresse 4 ne pourra maintenant plus être émis avant que toutes les autres adresses du registre aient été choisies. En outre, conformément à la deuxième loi II, l'autre symbole du même mot, c'est-à-dire le symbole c, ne pourra pas être émis avant deux coups, de façon à respecter l'intervalle minimum Lm ci-dessus défini, et égal à trois.

En conséquence, l'adresse suivante de la suite pilote est prise au hasard parmi les quatre autres adresses disponibles 1, 2, 5, ou 6. Par exemple, l'adresse 6 est choisie. Les deux premières adresses de la suite pilote sont donc : 4 6.

Il s'ensuit que le symbole f (qui se trouve à l'adresse 6 dans le registre) est émis, et forme donc le deuxième symbole de la suite canal, tandis qu'il est remplacé, à cette adresse 6 dans le registre, par le huitieme symbole à émettre, c'est-à-dire h.

Le contenu du registre devient alors : a b c g e h .

Compte tenu des deux lois I et II :
- les adresses 4 et 6 ne peuvent plus être choisies tant que les quatre autres adresses restantes ne l'ont pas été ;
- l'adresse 5 ne peut pas être choisie avant deux coups ; et
- l'adresse 3 ne peut pas être choisie avant encore un coup.

L'adresse suivante de la suite pilote ne peut être choisie au hasard qu'entre l'adresse 1 et l'adresse 2.

Choisissons l'adresse 1 : a est émis, et remplacé par i.

Le contenu du registre devient : i b c g e h

La première loi interdit de prendre comme nouvelle adresse 1, 4 ou 6. La seconde loi interdit de prendre l'adresse 2 pour encore deux coups, et l'adresse 5 pour encore un coup. On est donc obligé de prendre l'adresse 3, puis l'adresse 5, et enfin l'adresse 2, et l'on remarquera donc au passage qu'il n'existe plus de possibilité de choix pour ces trois dernières adresses.

L'obtention des six premières adresses de la suite pilote, et de la suite canal qui en découle, est finalement résumée dans le tableau suivant :

| REGISTRE | SUITE PILOTE | SUITE CANAL |
|----------|--------------|-------------|
| a  b  c  d  e  f | 4 | d |
| a  b  c  g  e  f | 6 | f |
| a  b  c  g  e  h | 1 | a |
| i  b  c  g  e  h | 3 | c |
| i  b  j  g  e  h | 5 | e |
| i  b  j  g  k  h | 2 | b |
| i  l  j  g  k  h |   |   |

Maintenant que les six adresses du registre ont toutes été choisies l'une après l'autre, elles redeviennent toutes disponibles. En prenant par exemple comme nouvelle première adresse l'adresse 3, le symbole j est émis et remplacé par le symbole m . Le symbole i ne peut pas être émis avant deux coups, de sorte que l'adresse 1 ne peut être choisie : le choix est possible entre les adresses 2, 4, 5 et 6. L'adresse 2 est par exemple choisie : 1 est émis, et remplacé par n. Les adresses 3 et 2 sont alors interdites par la première loi, tandis que l'adresse 1 l'est encore pour un coup et l'adresse 5 pour deux coups : le choix n'est possible qu'entre l'adresse 4 et l'adresse 6. L'adresse 4 est par exemple choisie, de sorte que g est émis et remplacé par o . Il n'existe maintenant, pour les trois coups suivants, plus de choix possible : il faudra successivement prendre 1 (i est émis et remplacé par p), puis l'adresse 5 (k est émis et remplacé par q) , et enfin l'adresse 6 (h est émis et remplacé par r).

L'obtention des six adresses suivantes (de la septième à la douzième) de la suite pilote, et de la suite canal qui en découle, est résumée dans le tableau suivant.

| REGISTRE | SUITE PILOTE | SUITE CANAL |
|----------|--------------|-------------|
| i  l  j  g  k  h | 3 | j |
| i  l  m  g  k  h | 2 | l |
| i  n  m  g  k  h | 4 | g |
| i  n  m  o  k  h | 1 | i |
| p  n  m  o  k  h | 5 | k |
| p  n  m  o  q  h | 6 | h |
| p  n  m  o  q  r |   |   |

La suite pilote débute donc ainsi : 4 6 1 3 5 2 3 2 4 1 5 6, et les douze premiers symboles envoyés le sont dans l'ordre suivant : d f a c e b j l g i k h. Il y a bien trois écarts (c'est-à-dire deux symboles) entre deux symboles initialement consécutifs d'un même mot codé initial (entre a et b, c et d, e et f, etc...).

A titre illustratif, l'obtention des dix huit premières adresses de la suite pilote, et des dix huit premiers symboles de la suite canal qui en découlent, est résumée dans le tableau suivant :

| REGISTRE | SUITE PILOTE | SUITE CANAL |
|---|---|---|
| a b c d e f | 4 | d |
| a b c g e f | 6 | f |
| a b c g e h | 1 | a |
| i b c g e h | 3 | c |
| i b j g e h | 5 | e |
| i b j g k h | 2 | b |
| i l j g k h | 3 | j |
| i l m g k h | 2 | l |
| i n m g k h | 4 | g |
| i n m o k h | 1 | i |
| p n m o k h | 5 | k |
| p n m o q h | 6 | h |
| p n m o q r | 5 | q |
| p n m o s r | 2 | n |
| p t m o s r | 1 | p |
| u t m o s r | 6 | r |
| u t m o s v | 3 | m |
| u t w o s v | 4 | o |
| u t w x s v | | |

et ainsi de suite...

Du côté réception, la suite-pilote inverse, et par suite le désentrelacement, sont obtenus comme suit :

L'obtention de cette suite-pilote inverse s'obtient en remplissant un registre réception, de même taille (six symboles) que celui utilisé côté émission, par les six premiers symboles qui ont été émis selon la suite canal précitée.

Ce registre réception est donc initialement rempli ainsi :

d f a c e b

La première adresse de la suite pilote inverse est la place du plus "petit" élément alors contenu dans ce registre réception (par "plus petit élément", on entend le symbole qui a le plus petit numéro d'ordre dans la suite des symboles correspondant au codage initial, avant entrelacement à l'émission) ; a est ce plus petit élément, et il est à la troisième place dans ce registre : la suite-pilote inverse commence donc par l'adresse 3.

Le symbole a est alors remplacé par le symbole suivant de la suite canal : j

Le registre réception est alors rempli ainsi :

d f j c e b

Le plus petit élément, b, est à la sixième place, de sorte que la suite pilote inverse se poursuit par 6.

Le registre devient alors :

d f j c e l

Et ainsi de suite, la suite pilote inverse étant la suivante :

3 6 4 1 5 2...

et le registre réception prenant successivement les états :

```
d f a c e b
d f j c e b
d f j c e l
d f j g e l
i f j g e l
i f j g k l
i h j g k l
. . . . . .
```

La suite pilote inverse est donc obtenue, après avoir initialement rempli le registre réception avec les six premiers symboles successifs de la suite canal, en prenant à chaque fois l'adresse, dans ce registre, du plus petit symbole et en le remplaçant simultanément par le symbole suivant de la suite canal.

Il est clair qu'inversement, si l'on est en possession de cette suite pilote inverse et qu'on lit et remplit le registre réception (initialement rempli par les six premiers symboles de la suite canal) avec la suite canal reçue, on va retrouver les symboles dans leur ordre initial (avant l'entrelacement à l'émission).

Pour le premier exemple qui vient d'être décrit, où :

$$Tv = Tc . Lm ,$$

il convient de remarquer que la deuxième loi n'est jamais transgressée, c'est-à-dire que l'intervalle minimum Lm entre deux symboles initialement successifs d'un même mot codé initial est toujours respecté. En revanche, les possibilités de choix pour la suite pilote sont limités, puisqu'on a vu précédemment que pour chaque série de six opérations de lecture/écriture du registre d'émission, le choix n'est plus possible à partir de la quatrième opération.

Pour créer plus d'imprévu, et donc plus de difficulté à l'attaque par un éventuel ennemi, il convient donc de choisir :

$$Tv > Tc . Lm$$

et c'est ce qui sera fait dans le deuxième exemple qui sera maintenant brièvement décrit, avec comme choix :

$$Tv = 8 ,$$

Te et Lm restant respectivement égaux à 2 et à 3, et la suite codée des symboles à émettre étant également la même.

Le registre d'émission est donc initialement rempli ainsi :

a b c d e f g h

La première adresse de la suite pilote est par exemple l'adresse 3. Le symbole c est émis et remplacé par i . L'adresse 3 n'est plus disponible, tandis que l'adresse 4 ne l'est pas pendant les deux coups suivants. Le contenu du registre devient :

a b i d e f g h

Le choix suivant se porte par exemple sur 5 : e est émis, remplacé par j. Les adresses 3 et 5 ne sont plus disponibles, l'adresse 4 ne l'est pas pendant le coup suivant, et l'adresse 6 pendant les deux coups suivants. Le contenu du registre est alors :

a b i d j f g h

Il reste quatre adresses possibles : 1, 2, 7 et 8. Choisissons 1 : a est émis et remplacé par k. Le resistre devient :

k b i d j f g h

Les adresses 5,3 et 1 ne peuvent plus être choisies; 4 redevient disponible, 2 ne l'est pas pendant deux coups, et 6 pendant encore un coup.

Il reste trois adresses possibles : 4, 7 et 8. On choisit 4 ; d est émis et remplacé par 1. Le registre devient :

k b i l j f g h

En continuant ainsi, on choisit ensuite l'adresse 6, puis l'adresse 2, puis l'adresse 7.

On s'aperçoit alors que les sept premières adresses ne peuvent pas être choisies en vertu de la première loi, et que la huitième et dernière adresse ne peut pas l'être non plus en vertu de la deuxième loi. Il faut donc alors transgresser la deuxième loi en appliquant alors la troisième Loi III ci-dessus définie, pour pouvoir continuer et choisir en conséquence l'adresse 8 pour la suite pilote. Ceci est heureusement récupéré par le fait que le code correcteur d'erreur utilisé est capable de corriger plusieurs erreurs. On constate finalement que, pour avoir plus d'imprévu qu'avec le vecteur de taille minimale :

$$Tv = Tc . Lm ,$$

Il convient de prendre un vecteur Tv de taille légèrement supérieure à cette taille minimale. Dans un tel cas, on est parfois obligé d'appliquer la troisième loi, ce qui peut ne pas être grave si l'on utilise un code correcteur d'erreurs capable de corriger plusieurs erreurs.

## Revendications

1. Procédé d'entrelacement pour dispositif de transmission numérique d'informations, du type consistant à, du côté émission :
   - remplir initialement un vecteur par une série S1 des Tv premiers symboles (a b c d e f) de la suite (ab, cd, ef, ...) des mots codés ;
   - à chacune des adresses (1 à 6) de ce vecteur, données l'une après l'autre par une suite-pilote (4 6 1 3 5 2...), prélever, pour l'incorporer dans la suite-canal à émettre (d f a c e b...), le symbole qui s'y trouve tout en le remplaçant aussitôt à cette même adresse par le symbole suivant, dans l'ordre des mots codés, de la série S2 des Tv symboles suivants (gh, ij, kl), jusqu'à ce que tous les symboles (a à f) de cette première série S1 aient été l'un après l'autre prélevés et remplacés par tous les symboles (g à l) de cette deuxième série S2,

   ledit procédé respectant la loi I suivante:

   I- une adresse dudit vecteur ne peut, au cours de l'émission des symboles d'une série Sn et de leur remplacement concommitant dans ce vecteur par ceux d'une série Sn+1, être choisie plusieurs fois, caractérisé en ce que ladite suite-pilote (..3 2 4 1 5 6...) est de type pseudo-aléatoire et en ce que ledit procédé consiste ensuite à :

   - prélever, d'une manière pseudo-aléatoire dictée par ladite suite-pilote (..3 2 4 1 5 6...), tous les symboles (i l j g k h) de cette deuxième série S2, en les remplaçant au fur et à mesure dans ce vecteur par les symboles dans l'ordre d'une troisième série S3 des Tv mots codés suivants (mn, op, qr), et ainsi de suite jusqu'à incorporation dans ladite suite-canal de l'ensemble desdits mots,

   en ce que la taille (Tv) dudit vecteur est au moins égale à la taille (Tc) d'un mot de code multipliée par la distance minimale (Lm) souhaitée après entrelacement de deux symboles appartenant initialement à un même mot codé,

   en ce que cette suite-pilote pseudo-aléatoire est réalisée en respectant les deux autres lois suivantes :

   II - lorsqu'une de ces adresses n a été choisie, on ne peut choisir, avant Lm fois, une adresse du vecteur où est inscrit, au moment du choix de cette adresse n, un autre symbole du même mot de code que celui qui contient le symbole se trouvant à cette adresse n au moment de son choix ;

   III - en cas de blocage, c'est-à-dire si l'on ne peut choisir d'adresse sans violer une des deux lois précédentes (I, II), on choisit une adresse qui, même si elle viole la deuxième loi II, ne viole pas la première loi I,

   et en ce que, du côté réception, le désentrelacement de la suite-canal reçue (d f a c e b...) est effectué en utilisant un autre vecteur de même taille (Tv) que celui utilisé du côté émission, ce vecteur étant tout d'abord rempli, à ses adresses successives (1 à 6) et dans l'ordre, par les Tv premiers symboles (d f a c e b) de cette suite-canal, à la suite de quoi ce vecteur est, de la même façon que du côté émission, simultanément lu et rempli par les symboles suivants (j l g i k h) de la suite-canal, aux adresses successives (3 6 4 1 5 2...) qui sont données par une suite-pilote inverse déterminée pour que les symboles (a b c d e f...) qui sont ainsi lus l'un après l'autre le soient dans l'ordre initial des symboles codés avant entrelacement.

2. Procédé selon la revendication 1, caractérisé en ce que ladite suite-pilote inverse est obtenue en choisissant à chaque fois l'adresse, dans ledit vecteur, du symbole qui a le plus petit numéro d'ordre dans la suite des symboles correspondant au codage initial.

## Patentansprüche

1. Verschachtelungsverfahren für eine digitale Datenübertragungsvorrichtung, wobei sendeseitig
   - ursprünglich ein Vektor durch eine Reihe S1 der Tv ersten Symbole (a, b, c, d, e, f) der Folge (ab, cd, ef, ...) der kodierten Wörter gefüllt wird,
   - an jeder der Adressen (1 bis 6) dieses Vektors, die nacheinander von einer Steuerfolge (4, 6, 1, 3, 5, 2, 1, ...) geliefert werden, das dort befindliche Symbol in die auszusendende Kanalfolge (d, f, a,

7

c, e, b, ...) eingefügt und sofort durch das nächstfolgende Symbol in der Reihenfolge der kodierten Wörter der Reihe S2 der Tv nächstfolgenden Symbole (gh, ij, kl) ersetzt wird, bis alle Symbole (a bis f) der ersten Reihe S1 nacheinander entnommen und durch alle Symbole (g bis l) der zweiten Reihe S2 ersetzt worden sind,

wobei dieses Verfahren das nachfolgende Gesetz I respektiert:

I - eine Adresse des Vektors kann während der Aussendung der Symbole einer Reihe Sn und dem sofortigen Ersatz dieser Symbole durch die einer Reihe Sn + 1 nur einmal ausgewählt werden,

dadurch gekennzeichnet, daß die Steuerfolge (.. 3, 2, 4, 1, 5, 6, ...) pseudozufällig ist und daß das Verfahren weiter darin besteht

- auf eine durch die Steuerfolge (... 3, 2, 4, 1, 5, 6 ..) diktierte pseudozufällige Art alle Symbole (l, 1, j, g, k, h) dieser zweiten Reihe S2 auszuwählen und sie nach und nach im Vektor durch die Symbole in der Reihenfolge einer dritten Reihe S3 der Tv nächstfolgenden kodierten Wörter (mn, op, qr) zu ersetzen usw., bis alle Wörter in die Kanalfolge eingebaut worden sind,

daß die Vektorgröße (Tv) mindestens gleich der Größe (Tc) eines Kodeworts multipliziert mit dem gewünschten Mindestabstand (Lm) nach der Verschachtelung zweier ursprünglich einem gleichen kodierten Wort angehörender Symbole ist,

daß diese pseudozufällige Steuerfolge unter Berücksichtigung der beiden nachfolgenden weiteren Gesetze aufgestellt wird:

II - wenn eine dieser Adressen n gewählt worden ist, dann kann man während Lm Zyklen eine Adresse des Vektors nicht auswählen, an der im Augenblick der Auswahl dieser Adresse n ein anderes Symbol desselben Kodeworts wie das steht, das das Symbol an dieser Adresse n während seiner Auswahl enthält,

III - bei einer Blockierung, d.h. wenn man keine Adresse wählen kann, ohne eines der beiden obigen Gesetze (I, II) zu verletzen, wählt man eine Adresse, die zwar das zweite Gesetz II, nicht aber das erste Gesetz I verletzt,

und daß auf der Empfangsseite die Entschachtelung der empfangenen Kanalfolge (d, f, a, c, e b ...) unter Verwendung eines anderen Vektors derselben Größe (Tv) wie der auf der Sendeseite verwendete erfolgt, der zuerst an seinen aufeinanderfolgenden Adressen (1 bis 6) und in der Reihenfolge durch die Tv ersten Symbole (d, f, a, c, e, b) dieser Kanalfolge gefüllt wird, worauf dieser Vektor genauso wie auf der Sendeseite gleichzeitig gelesen und mit den nachfolgenden Symbolen (j, l, g, i, k, h) der Kanalfolge an den aufeinanderfolgenden Adressen (3, 6, 4, 1, 2, 5, 2 ...) gefüllt wird, die durch eine umgekehrte Steuerfolge bestimmt werden, so daß die Symbole (a, b, c, d, e, f ...), die so nacheinander gelesen werden, in der ursprünglichen Reihenfolge der kodierten Symbole vor der Verschachtelung gelesen werden.

2. Verfahren nach Anspruch 1, dadurch gekennzeichnet, daß die umgekehrte Steuerfolge erhalten wird, indem jedesmal die Adresse des Symbols im Vektor gewählt wird, das die kleinste Ordnungsnummer in der Folge der Symbole hat, die der ursprünglichen Kodierung entspricht.

## Claims

1. A method of interleaving for a digital data transmission system, of the type consisting in, at the transmission end:
   · initially filling a vector with a series S1 of the first Tv symbols (a b c d e f) of the sequence (ab, cd, ef, ...) of code words;
   · at each of the addresses (1 to 6) of said vector given one after the other by a pilot sequence (4 6 1 3 5 2 ...), taking the symbol from that address to incorporate it into the channel sequence for transmission (d f a c e b ...), and immediately replacing it at said address with the following symbol in code word order (gh, ij, kl) taken from the series S2 of the following Tv symbols, until all of the symbols (a to f) of said first series S1 have been taken one after the other and replaced by all of the symbols (g to l) of said second series S2, said method respecting the following law I:
   I no address in said vector may be selected more than once while transmitting the symbols of a series Sn and replacing them in the vector with the symbols of a series Sn+1,
   characterized in that said said pilot sequence (... 3 2 4 1 5 6 ...) is of pseudo-random type and in that said method consists next in:
   · taking all of the symbols (i l j g k h) of said second series S2 in a pseudo-random manner specified by said pilot sequence (... 3 2 4 1 5 6 ...), replacing each of them in turn in said vector with symbols taken in order from a third series S3 of the following Tv symbols in code word order (mn, op, qr), and so on until all of said words have been incorporated in said channel sequence,

and in that the size (Tv) of said vector is not less than the size (Tc) of a code word multiplied by the minimum distance (Lm) desired after interleaving between two symbols initially belonging to the same code word,

and in that said pseudo-random pilot sequence is established, obeying the following two other laws:

II once one of these addresses n has been selected, any other address in the vector that contains another symbol in the same code word as the code word that contains the symbol found at the address n when said address was selected may not itself be selected until Lm turns later; and

III if blocking occurs, i.e. if an address cannot be selected without transgressing one or other of the two preceding laws (I,II), then an address is selected which does not transgress the first law I, even if it does transgress the second law II;

and, on reception, the received signal sequence (d f a c e b ...) is deinterleaved by using another vector of the same size (Tv) as the vector used on transmission, said vector being initially filled in successive addresses (1 to 6) with the first Tv symbols (d f a c e b) from the channel sequence in the order in which they are received, after which, in the same manner as at the transmission end, the symbols are simultaneously read from the vector and replaced by the following symbols (j l g i k h) of the channel sequence at successive addresses (3 6 4 1 5 2 ...) given by an inverse pilot sequence determined so that the symbols (a b c d e f ...) read in this way one after the other are in the initial order of the encoded symbols before interleaving.

2. A method according to claim 1, characterized in that said inverse pilot sequence is obtained on each occasion by selecting the address in said vector of the symbol having the lowest order number in the sequence of symbols corresponding to the initial coding.